# EUROPEAN PATENT APPLICATION

(11) **EP 1 566 836 A1**
(43) Date of publication of application: **24.08.2005**
(21) Application number: 03775920.6
(22) Date of filing: 27.11.2003
(51) Int. Cl.: H01L 21/768, H01L 21/3205, H01L 21/3213

(54) **SEMICONDUCTOR MULTILAYER INTERCONNECTION FORMING METHOD**

(30) Priority: 27.11.2002 JP 2002343865; 27.11.2002 JP 2002343866
(71) Applicant: TOKYO OHKA KOGYO CO., LTD., Kanagawa 211-0012 (JP)
(72) Inventor: HAGIWARA, Yoshio Tokyo Ohka Kogyo Co., Ltd., Kawasaki-shi Kanagawa 211-0012 (JP); TANAKA, Takeshi Tokyo Ohka Kogyo Co., Ltd., Kawasaki-shi Kanagawa 211-0012 (JP)
(74) Representative: HOFFMANN EITLE
(86) International application number: PCT/JP2003/015162
(87) International publication number: WO 2004/051740

(57) **Abstract**

In a method for forming a wiring using a dual damascene process in which a multilayer wiring structure is formed by embedding a first etching space formed in an interlayer insulating layer and a second etching space which communicates thereto with a conductor material, a number of steps may be reduced and flexibility in the step management is enhanced without deteriorating a low dielectric material layer which constitutes the interlayer insulating layer. Therefor, a filler material whose major ingredient is a spin-on-glass material capable of being easily removed by a stripping solution which gives no damage to the interlayer insulating layer is used as a material filled in the first etching space in order to protect a lower wiring layer from exposure light to form a photoresist pattern for forming the second etching space. Furthermore, no light absorbing material for absorbing the exposure light is added to this filler material. Instead, a reflection preventing film capable of being processed by dry etching or a reflection preventing film which is soluble in a developer is formed on a filler material layer.

## Description

### TECHNICAL FIELD

The present invention relates to a method for forming a semiconductor multilayer wiring where a lower wiring layer formed on a semiconductor substrate and an upper wiring layer formed thereon by the intermediary of an interlayer insulating layer, in which the lower and the upper wiring layer are connected by a via wiring which penetrates the interlayer insulating layer, and more particularly relates to a method for forming a semiconductor multilayer wiring where the via wiring and the upper wiring layer are formed by a simpler dual damascene process.

### BACKGROUND ART

As is well-known, in a basic wiring structure in a semiconductor integrated circuit, a lower wiring layer directly or indirectly formed on a semiconductor substrate and an upper wiring layer formed on this lower wiring layer by the intermediary of an interlayer insulating layer are connected by a via wiring formed to penetrate the interlayer insulating layer. A multilayer wiring structure in the semiconductor integrated circuit is formed by complicating and multiplying this wiring structure.

Conventionally, this wiring structure has been formed by repeating the formation of each layer such as a conductor layer and interlayer insulating layer laminated on the semiconductor substrate and the patterned by etching thereof. In such a sequential formation method in which the multilayer wiring is formed by repeating such lamination and etching, many steps are required, and it has been difficult to reduce production cost. Therefore, an inlaid method generally referred to as a damascene method is currently employed. This damascene method is a wiring formation method in which wiring slots referred to as a via hole and a trench for forming the via wiring and the upper wiring layer have been formed in the interlayer insulating layer and a conductor material is then embedded in space therein. Particularly, a variation of the damascene method wherein the via wiring and the upper wiring layer are formed simultaneously is referred to as a dual damascene process. By employing this damascene method, it has become possible to use copper which was unable to be used as the conductor material. That is, although copper is a suitable material as the conductor material for fine wiring because of its excellent electromigration resistance compared to aluminium, it is difficult to give the etching, and thus, copper was unable to be used for the conventional sequential formation method of the multilayer wiring. However, by the use of the aforementioned damascene method, it has become possible to use the much-awaited copper as the conductor material.

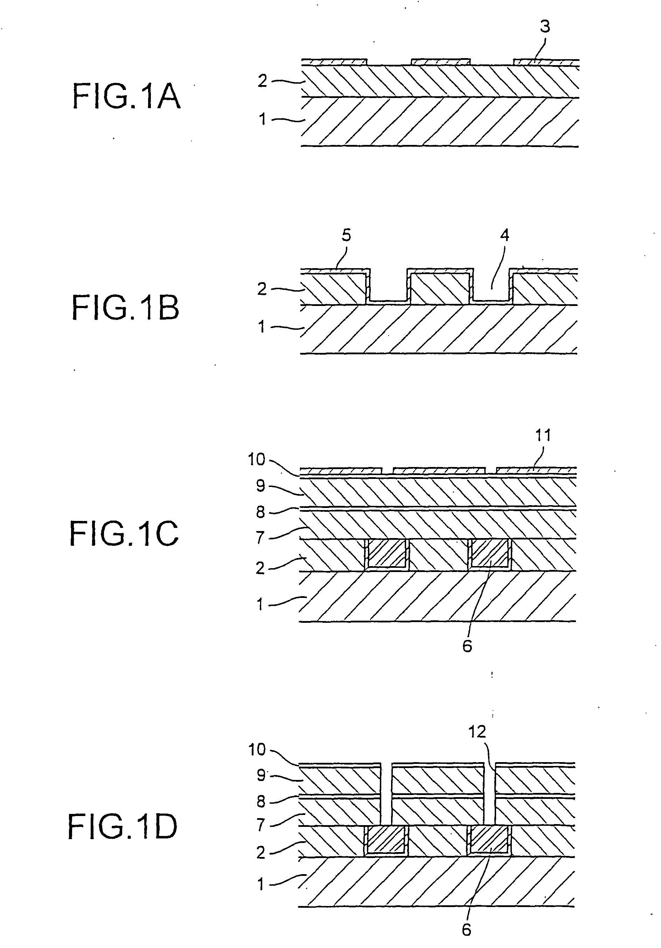

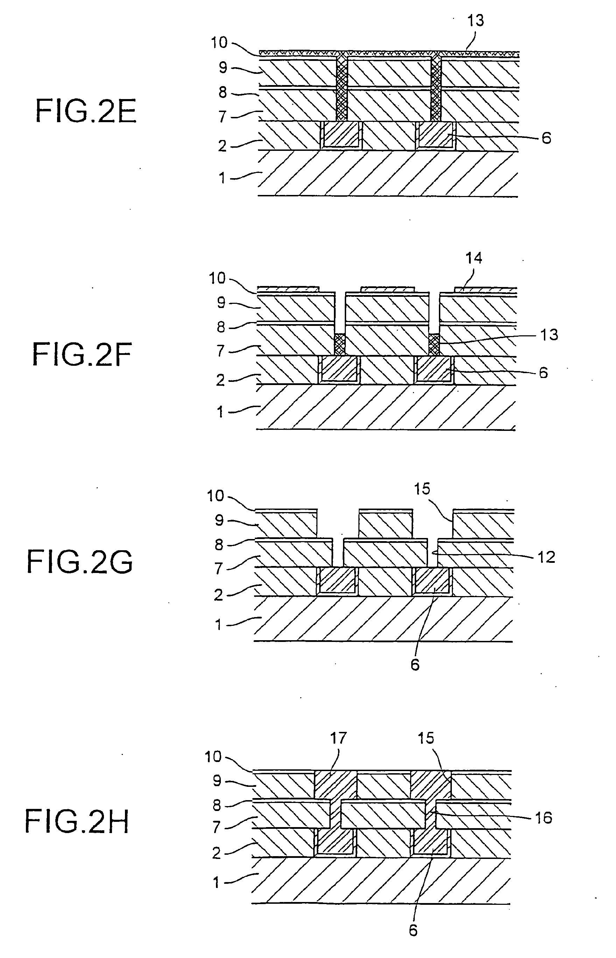

Basic steps of such a dual damascene process will be illustrated with reference to Figs. 1 and 2.

First, an interlayer insulating layer 2 is formed on a substrate 1 by a CVD method or a spin coating method as shown in Fig. 1A. SiO₂ and SOG (spin on glass) are used for a material which constitutes this interlayer insulating layer 2. A resist film 3 is formed on this interlayer insulating layer 2, and patternized. The interlayer insulating layer 2 is selectively etched using this patternized resist film 3 as a mask, and subsequently a trench 4 is formed by removing the resist film 3 as shown in Fig. 1B. Then, for enhancing adhesiveness of copper to be embedded in this trench 4 to the interlayer insulating layer 2 as well as for preventing copper from diffusing into the interlayer insulating layer 2, a barrier metal film is formed inside this trench 4 by depositing a barrier metal 5 on the surface of the interlayer insulating layer 2 in which the trench 4 has been formed as described above. Thereafter, copper is embedded in the trench 4 using electrolytic plating to form a lower wiring layer 6 as shown in Fig. 1C.

Subsequently, copper and the residual barrier metal 5 which have adhered to the surface of the interlayer insulating layer 2 at that time are removed by chemical mechanical polishing (CMP) to flatten the surface of the interlayer insulating layer 2. Then, a first low dielectric material layer 7, a first etching stopper film 8, a second low dielectric material layer 9 and a second etching stopper film 10 are sequentially laminated thereon. Then, a resist mask 11 having a pattern for forming a via hole is formed on the second etching stopper film 10. As shown in Fig. 1D, the etching is performed using the resist mask 11 to form the via hole 12 which penetrates through the second etching film 10, the second low dielectric material layer 9, the first etching stopper film 8 and the first low dielectric material layer 7 to the surface of the lower wiring layer 6. Subsequently, as shown in Fig. 2E, a filler material 13 such as a photoresist material is filled in the via hole 12. This filler material 13 is etched back to leave the material with a predetermined thickness at a bottom of the via hole 12 as shown in Fig. 2F, and further a resist mask 14 having a pattern for forming a trench is formed on the second etching stopper film 10. Using this resist mask 14, as shown in Fig. 2G, the second etching stopper film 10 and the second low dielectric material layer 9 are etched to form a trench 15, and the filler material 13 which has been remaining at the bottom of the via hole 12 is removed. Thereafter, copper is embedded in the via hole 12 and the trench 15 to form a via wiring 16 and an upper wiring layer 17 as shown in Fig. 2H. This realizes a multilayer wiring structure where the lower wiring layer 6 and the upper wiring layer 17 are electrically connected by the via wiring 16.

The filler material is used in the method for forming the multilayer wiring, and this filler material plays the following role. That is, when the trench is formed by etching after forming the via hole, existence of an uncovered part of the substrate at the bottom of the via hole may cause damage of the lower wiring layer present on the substrate surface due to etching gas for the trench formation, which may lead to poor wiring. Thus, the filler material is filled in the via hole to protect the lower wiring layer during the trench formation.

Conventionally, a photoresist composition has been used as this filler material, but when the photoresist composition is filled in the via hole, bubbles are sometimes produced to cause insufficient filling. Thus as a new filler material, it has been proposed to use a solution in which a thermally crosslinking compound is dissolved in an organic solvent (JP 2000-195955 A).

However, this organic film used as the filler material is problematic in that it is not easy to remove the filler material remaining in the via hole after completing the role of the filler material. Thus it is necessary to remove such a remaining filler material by oxygen plasma ashing. In this case, it is likely that the ashing gas (usually oxygen based gas) damages the low dielectric material layer. The damage includes a change of Si-R bond to Si-OH bond and an alteration of a dielectric constant (k) in the low dielectric material layer.

As other examples of the filler material, a spin-on-glass material or a composition where a highly light-absorbing dye is added thereto is disclosed (JP 2000-195955 and US Patent No. 6,329,118). Since the spin-on-glass material is a transparent material, the light for exposure upon patterning the resist for forming the trench may reach the substrate surface and may be reflected to re-enter into the resist, which may lead to deterioration of pattern resolution of the resist. The purpose of adding the highly light-absorbing dye to this composition is to prevent pattern resolution of the resist from being deteriorated. This filler material composition is advantageous in that the filler material remaining in the via hole may be removed by a stripping solution containing hydrofluoric acid because the spin-on-glass material which is a major ingredient is highly compatible with hydrofluoric acid. However, on the contrary, the highly light-absorbing dye which is an additive in this filler material is easily deteriorated, and thus storage stability of a filler material solution is low. Therefore, the stability of an embedded film also easily becomes low, which largely limits flexibility of step management. As another disadvantage, the highly light-absorbing dye contained in the composition may cause intermixing between the embedded film and the upper layer film.

US Patent No. 6,365,529 discloses a constitution where a reflection preventing film for blocking the reflected light is further provided on the filler material layer and a resist layer for forming the trench is formed on this reflection preventing film. It is described that organic and inorganic materials commonly used are used for materials of this reflection preventing film.

For the materials of the reflection preventing film, several examples obtained by improving the composition where the dye is added to the spin-on-glass material are proposed (e.g., JP 2001-92122 A, US Patent No. 6,268,457). JP 2001-92122 A discloses a reflection preventing film material obtained by improving a silane compound which is a major ingredient, whereby a etching rate of the reflection preventing film becomes faster than that of the photoresist. US Patent No. 6,268,457 discloses a reflection preventing film material obtained by combining a certain highly light-absorbing ingredient with an alkoxysilane based material to enhance light absorbability.

As described above, in the conventional method for forming the multilayer wiring by the dual damascene process, when the organic film such as photosensitive resin and thermoplastic resin is used for the filler material, it is not easy to remove the filler material remaining in the via hole after completing the role of the filler material, and the residue has to be removed by the oxygen plasma ashing. Production in such a manner requires a large number of production steps, and therefore requires high cost. As another problem, the oxygen plasma gas gives damages to the low dielectric material layer.

When the spin-on-glass material having high compatibility with the stripping solution containing the hydrofluoric acid as the major ingredient is employed for facilitating removal of the residual filler material, a highly light-absorbing dye must be added so that the exposure light does not reach the substrate surface, due to the transparency of the spin-on-glass material. Since the additive, highly light-absorbing dye, is easily deteriorated, the storage stability of the filler material solution is low, and thus, the stability of the embedded film easily becomes low, which largely limits the flexibility of the production step management. As another disadvantage, the highly light-absorbing dye contained in the composition may cause intermixing between the embedded film and the upper layer film.

The present invention has been made in the light of the above circumstance, and it is an object of the invention to reduce the production steps and to enhance the flexibility of the production step management in the method for forming the semiconductor multilayer wiring using the dual damascene process, without deteriorating the low dielectric material layer which constitutes the interlayer insulating layer.

### DISCLOSURE OF THE INVENTION

In order to solve the above subjects, the present inventors restudied a relation between a role of a filler material which is essential for a damascene method and a means for reducing reflection of the exposure light upon the formation of a trench in the overall course of formation steps of a semiconductor multilayer wiring in a dual damascene process, further studied suitable materials as the filler material and a reflection preventing film material, and thereby led to obtain the following findings.
(i) In order to remove the residual filler material completely and simply/easily without deteriorating a low dielectric material layer, a spin-on-glass material should be employed as a major ingredient of the filler material.
(ii) Rather than adding the highly light-absorbing dye which advantageously reduces transperancy of the spin-on-glass material but which also inadvantageously reduces storage stability, it is more advantageous to give the filler material only a role as the filler material, and provide a reflection preventing film having high storage stability and high removability, for preventing reflection of the exposure light on the substrate. If such a constitution is employed, stable supply of the material and the step management become easy, and finally the multilayer wiring is easily formed.
(iii) By the use of the filler material whose major ingredient is the spin-on-glass material, the etching rate may be made fast equally to or faster than that of the low dielectric material layer, which results in easy formation of the second etching space.
(iv) In a process where a photoresist layer is provided on a just above layer of the spin-on-glass layer, variations among lots frequently occurred in evaluation as to matching of the photoresist layer with the resist film.
However, the matching may be facilitated by providing the reflection preventing layer therebetween.

The present invention has been made based on such findings. A first method for forming a semiconductor multilayer wiring is characterized in that said wiring comprises a lower wiring layer formed on a semiconductor substrate and an upper wiring layer formed thereon by the intermediary of an interlayer insulating layer, said lower wiring layer and said upper wiring layer are connected by a via wiring which penetrates through said interlayer insulating layer, and that said method comprises: a step of forming the interlayer insulating layer wherein said interlayer insulating layer composed of at least a low dielectric material layer is laminated on said lower wiring layer; a step of forming a first etching space wherein the first etching space is formed in said interlayer insulating layer by forming a photoresist layer on said interlayer insulating layer, giving patterned exposure thereto, developing to form a photoresist pattern, and etching using this photoresist pattern as a mask; a step of embedding wherein a filler material which at least contains a spin-on-glass material as a major ingredient is applied to said interlayer insulating layer, to embed said filler material in said first etching space; a step of forming a reflection preventing film wherein the reflection preventing film capable of being processed by dry etching is formed on a filler material layer formed on said interlayer insulating layer; a step of forming a photoresist pattern wherein the photoresist pattern is formed by forming a photoresist layer on said reflection preventing film, irradiating said photoresist layer with patterned light, and developing by an alkali developer; a step of processing the reflection preventing film wherein an exposed part of said reflection preventing film is processed by dry etching using said photoresist pattern as a mask; a step of forming a second etching space and removing the filler material wherein etching is performed using said photoresist pattern as a mask to remove said interlayer insulating layer above said first etching space in accordance with a predetermined pattern for forming the second etching space which communicates with said first etching space, and simultaneously to remove the filler material in said first etching space; and a step of simultaneous wiring formation wherein said first and second etching spaces are simultaneously embedded with a conductor material to simultaneously form a via wiring and an upper wiring layer.

A second method for forming a semiconductor multilayer wiring is characterized in that said method comprises a lower wiring layer formed on a semiconductor substrate and an upper wiring layer formed thereon by the intermediary of an interlayer insulating layer, said lower wiring layer and said upper wiring layer are connected by a via wiring which penetrates through said interlayer insulating layer, and that said method comprises: a step of forming an interlayer insulating layer wherein said interlayer insulating layer composed of at least a low dielectric material layer is laminated on said lower wiring layer; a step of forming a first etching space wherein the first etching space is formed in said interlayer insulating layer by forming a photoresist layer on said interlayer insulating layer, giving patterned exposure thereto, developing to form a photoresist pattern, and etching using this photoresist pattern as a mask; a step of embedding wherein a filler material which at least contains a spin-on-glass material as a major ingredient is applied to said interlayer insulating layer, to embed said filler material in said first etching space; a step of forming a reflection preventing film wherein a developer-soluble reflection preventing film is formed on a filler material layer formed on said interlayer insulating layer; a step of forming a photoresist wherein a photoresist layer is formed on said developer-soluble reflection preventing film; a step of developing the resist and removing the reflection preventing film wherein said photoresist layer is irradiated with patterned light and, with an alkali developer, the photoresist layer is developed, and simultaneously a part of the reflection preventing film that is not covered by the remaining photoresist pattern which has remained during the development is removed; a step of forming a second etching space and removing the filler material wherein etching is performed using said photoresist pattern as a mask to remove said interlayer insulating layer above said first etching space in accordance with a predetermined pattern for forming the second etching space which communicates with said first etching space, and simultaneously to remove the filler material in said first etching space; and a step of simultaneous wiring formation wherein said first and second etching spaces are simultaneously embedded with a conductor material to simultaneously form a via wiring and an upper wiring layer.

In the aforementioned constitutions, the first etching space means a trench or a via hole, and the second etching space means the via hole or the trench.

The present invention described in the above, the other objects, characteristics and advantages of the invention will be manifested in the following detailed description of the invention using drawings.

### BRIEF DESCRIPTION OF THE DRAWINGS

Figs. 1A to 1D are explanatory views showing first half steps of a conventional method for forming a semiconductor multilayer wiring using a dual damascene process;
Figs 2E to 2H are explanatory views showing last half steps of the conventional method for forming a semiconductor multilayer wiring using the dual damascene process;
Figs 3A to 3D are explanatory views showing first half steps of the first method for forming a semiconductor multilayer wiring according to the present invention using a dual damascene process;
Fig. 4E to 4H are explanatory views showing last half steps of the first method for forming the semiconductor multilayer wiring according to the present invention using the dual damascene process;
Figs. 5A to 5D are explanatory views showing first half steps of the second method for forming a semiconductor multilayer wiring according to the present invention using a dual damascene process; and
Figs 6E to 6H are explanatory views showing last half steps of the second method for forming the semiconductor multilayer wiring according to the present invention using the dual damascene process.

### BEST MODE FOR CARRYING OUT THE INVENTION

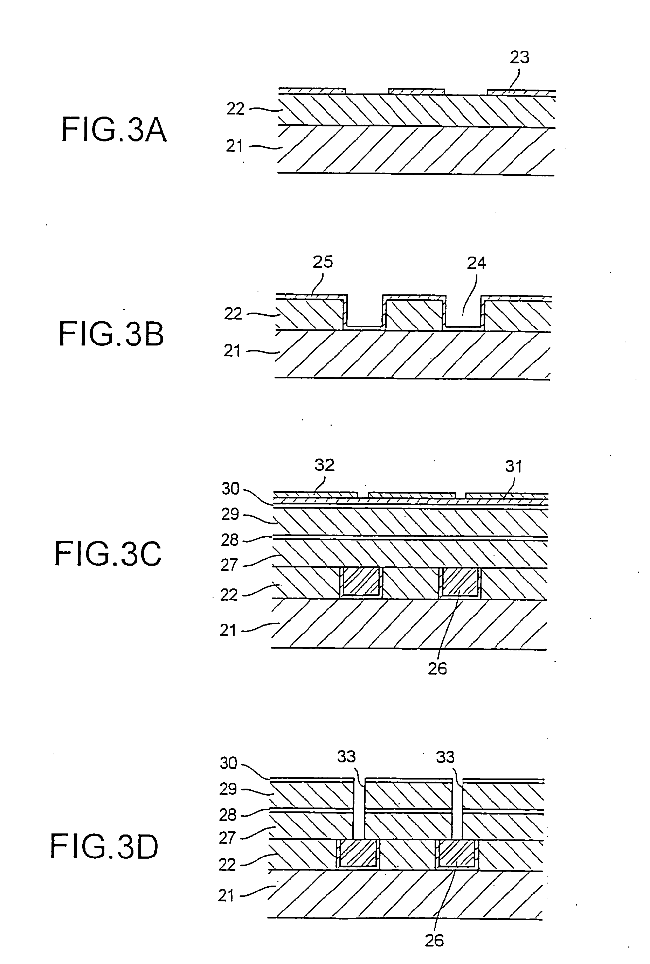

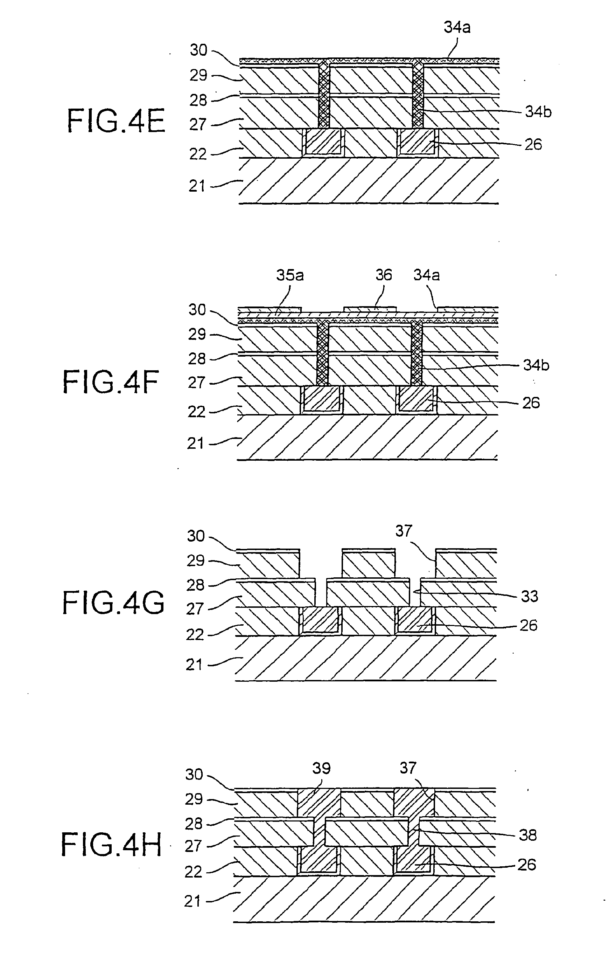

One example of the first method for forming the semiconductor multilayer wiring according to the present invention will be illustrated in more detail with reference to Figs 3 and 4.

First, as shown in Fig. 3A, a low dielectric material layer (interlayer insulating layer) 22 is formed on a substrate 21 by a CVD method or a spin coating method. A resist film 23 is formed on this low dielectric material layer 22, and patternized. The low dielectric material layer 22 is selectively etched using this patternized resist film as a mask, and subsequently the resist layer 23 is removed to form a trench 24 as shown in Fig. 3B. Then, a barrier metal film for enhancing adhesiveness of copper to be embedded in this trench 24 to the low dielectric material layer 22 as well as preventing copper from diffusing into the low dielectric material layer 22 is formed on an internal surface of the trench 24 by depositing a barrier metal 25 on the surface of the low dielectric material layer 22 where the trench 24 has been formed as aforementioned. Thereafter, as shown in Fig. 3C, copper is embedded in the trench 24 using electrolytic plating to form a lower wiring layer 26.

Copper and the residual barrier metal 25 which have adhered to the surface of the low dielectric material layer 22 at this stage are then removed by chemical mechanical polishing (CMP) to flatten the surface of the low dielectric material layer 22. Then, a first low dielectric material layer 27, a first etching stopper film 28, a second low dielectric material layer 29 and a second etching stopper film 30 are sequentially laminated thereon. Then, a reflection preventing film 31 is formed on the second etching stopper film 30. A resist is coated on this reflection preventing film 31, and patterning for forming a via hole is given to form a resist mask 32. Then, as shown in Fig. 3D, a via hole 33 which penetrates through the reflection preventing film 31, the second etching stopper film 30, the second low dielectric material layer 29, the first etching stopper film 28 and the first low dielectric material layer to the surface of the lower wiring layer 26 is formed by etching using the resist mask 32. Subsequently, after removing the resist mask 32 and the reflection preventing film 31, a filler material is filled in the via hole 33 by uniformly coating the filler material whose major ingredient is a spin-on-glass material on the second etching stopper 30 as shown in Fig. 4E. As shown in Fig. 4F, a reflection preventing film 35a capable of being processed by dry etching is laminated on a filler material layer 34a formed on the second etching stopper 30, and a resist mask 36 having a pattern for forming the trench is formed on this reflection preventing film 35a. An uncovered part of this reflection preventing film 35a that is uncovered with the resist mask 36 is then processed by dry etching using this resist mask 36 as a mask. Subsequently, using the resist mask 36, the second etching stopper film 30 and the second low dielectric material layer 29 are etched to form a trench 37, and simultaneously the filler material 34b in the via hole 33 is removed as shown in Fig. 4G. Thereafter, the reflection preventing film 35a is removed, and the filler material layer 34a on the second etching stopper layer 30 and the residual filler material 34b remaining in the via hole 33 after the etching step are then completely removed by a stripping solution containing hydrofluoric acid. Thereafter, copper is embedded in the via hole 33 and the trench 37 to simultaneously form a via wiring 38 and an upper wiring layer 39 as shown in Fig. 4H. This realizes the multilayer wiring structure where the lower wiring layer 26 and the upper wiring layer 39 are electrically connected by the via wiring 38.

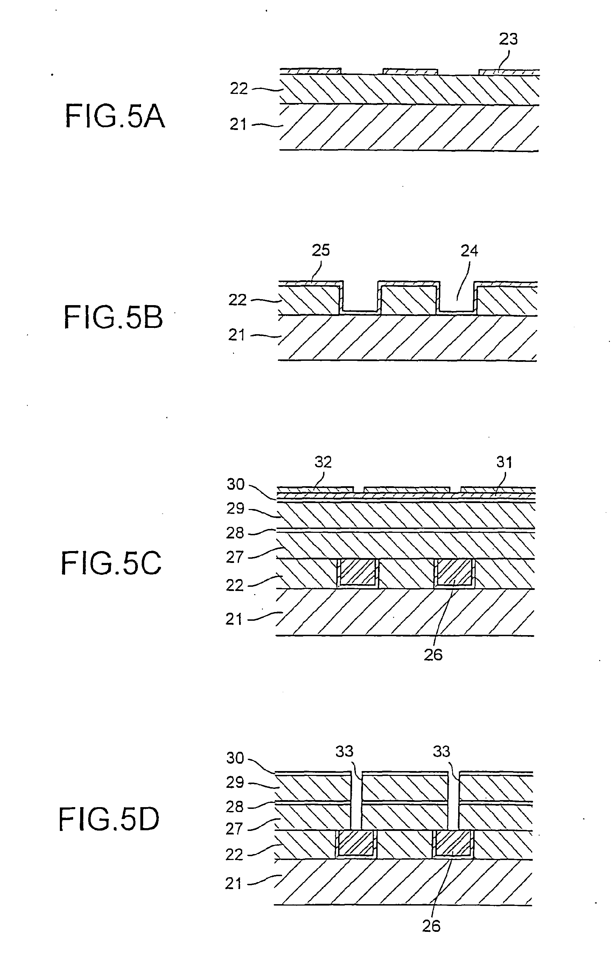

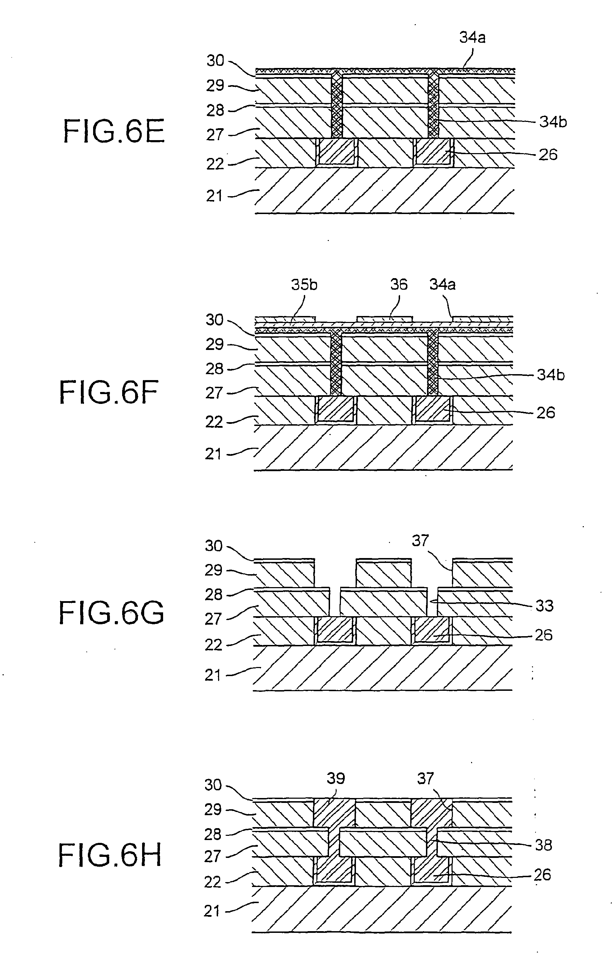

Subsequently, one example of the second method for forming the semiconductor multilayer wiring according to the present invention is illustrated in more detail with reference to Figs 5 and 6. In these Figs. 5 and 6, the same signs are allotted to the same component as the component in Figs 3 and 4, for facilitating the understanding of the present invention.

First, as shown in Fig. 5A, a low dielectric material layer (interlayer insulating layer) 22 is formed on a substrate 21. A resist film 23 is formed on this low dielectric material layer 22, and patternized. The low dielectric material layer 22 is selectively etched using this patternized resist film 23 as a mask and subsequently the resist layer 23 is removed to form a trench 24 as shown in Fig. 5B. Then, a barrier metal film for enhancing adhesiveness of copper to be embedded in this trench 24 to the low dielectric material layer 22 as well as preventing copper from diffusing into the low dielectric material layer 22 is formed on an internal surface of the trench 24 by depositing a barrier metal 25 on the surface of the low dielectric material layer 22 in which the trench 24 has been formed as aforementioned. Thereafter, as shown in Fig. 5C, copper is embedded in the trench 24 using electrolytic plating to form a lower wiring layer 26.

Subsequently, copper and the residual barrier metal 25 which have adhered to the surface of the low dielectric material layer 22 at that time are then removed by chemical mechanical polishing (CMP) to flatten the surface of the low dielectric material layer 22. Then, a first low dielectric material layer 27, a first etching stopper film 28, a second low dielectric material layer 29 and a second etching stopper film 30 are sequentially laminated thereon. Then, a reflection preventing film 31 is formed on the second etching stopper film 30. A resist is coated on this reflection preventing film 31, and patterning for forming a via hole is given to form a resist mask 32. Then, as shown in Fig. 5D, a via hole 33 which penetrates through the reflection preventing film 31, the second etching stopper film 30, the second low dielectric material layer 29, the first etching stopper film 28 and the first low dielectric material layer 27 to the surface of the lower wiring layer 26 is formed by etching using the resist mask 32. Subsequently, after removing the resist mask 32 and the reflection preventing film 31, a filler material is filled in the via hole 33 by uniformly coating the filler material whose major ingredient is a spin-on-glass material on the second etching stopper 30 as shown in Fig. 6E. As shown in Fig. 6F, a developer-soluble reflection preventing film 35b is laminated on a filler material layer 34a formed on the second etching stopper 30, and a resist mask 36 having a pattern for forming a trench is formed on this reflection preventing film 35b. When this resist mask 36 is developed by an alkali developer, an exposed part of the developer-soluble reflection preventing film 35b uncoated with this resist mask 36 is simultaneously removed. Subsequently, the second etching stopper film 30 and the second low dielectric material layer 29 are etched using the resist mask 36 to form a trench 37 and simultaneously the filler material in the via hole 33 is removed as shown in Fig. 6G. Thereafter, the reflection preventing film 35b is removed, and the filler material layer 34a on the second etching stopper layer 30 and the residual filler material 34b remaining in the via hole 33 after the etching step are then completely removed by a stripping solution containing hydrofluoric acid. Thereafter, copper is embedded in the via hole 33 and the trench 37 to simultaneously form a via wiring 38 and an upper wiring layer 39 as shown in Fig. 6H. This realizes the multilayer wiring structure where the lower wiring layer 26 and the upper wiring layer 39 are electrically connected by the via wiring 38.

Although the via hole is formed in advance in the above illustration, it is also possible to form the trench in advance. It is obvious that the present invention is also applicable to the latter case.

In the method for forming the semiconductor multilayer wiring of the present invention having the aforementioned features, the spin-on-glass material suitably used is one obtained by hydrolyzing at least one compound selected from
(A) a compound represented by Si(OR¹)ₐ(OR²)_{b}(OR³)_{c}(OR⁴)_{d} wherein R¹, R², R³ and R⁴ are each independently an alkyl group having 1 to 4 carbon atoms or a phenyl group, and a, b, c and d are integers which fulfill a condition of 0≤a≤4, 0≤b≤4, 0≤c≤4, 0≤d≤4 and a+b+c+d=4;
(B) a compound represented by R⁵Si(OR⁶)ₑ(OR⁷)_{f}(OR⁸)_{g} wherein R⁵ is a hydrogen atom or an alkyl group having 1 to 4 carbon atoms, R⁶, R⁷ and R⁸ are each an alkyl group having 1 to 3 carbon atoms or a phenyl group, and e, f and g are integers which fulfill a condition of 0≤e≤3, 0≤f≤3, 0≤g≤3 and e+f+g=3; and
(C) a compound represented by R⁹R¹⁰Si(OR¹¹)ₕ(OR¹²)ᵢ wherein R⁹ and R¹⁰ are a hydrogen atom or an alkyl group having 1 to 4 carbon atoms, R¹¹ and R¹² are each an alkyl group having 1 to 3 carbon atoms or a phenyl group, and h and i are integers which fulfill a condition of 0≤h≤2, 0≤i≤2 and h+i=2, by acid action in the presence of water.

Examples of the above compound of (A) may include tetraalkoxysilane such as tetramethoxysilane, tetraethoxysilane, tetrapropoxysilane, tetrabutoxysilane, tetraphenyloxysilane, trimethoxymonoethoxysilane, dimetoxydiethoxysilane, triethoxymonomethoxysilane, trimethoxymonopropoxysilane, monomethoxytributoxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane and monomethoxymonoethoxypropoxymonobutoxysilane or oligomers thereof, and among them, tetramethoxysilane, tetraethoxysilane or oligomers thereof are preferable.

Examples of the compound of (B) may include trimethoxysilane, triethoxysilane, tripropoxysilane, triphenyloxysilane, dimethoxymonoethoxysilane, diethoxymonomethoxysilane, dipropoxymonomethoxysilane, dipropoxymonoethoxysilane, diphenyloxymonomethoxysilane, diphenyloxymonoethoxysilane, diphenyloxymonopropoxysilane, methoxyethoxypropoxysilane, monopropoxydimethoxysilane, monopropoxydiethoxysilane, monobutoxydimethoxysilane, monophenyloxydiethoxysilane, methyltrimethoxysilane, methyltriethoxysilane, methyltripropoxysilane, ethyltrimethoxysilane, ethyltripropoxysilane, ethyltriphenyloxysilane, propyltrimethoxysilane, propyltriethoxysilane, propyltriphenyloxysilane, butyltrimethoxysilane, butyltriethoxysilane, butyltripropoxysilane, butyltriphenyloxysilane, methylmonomethoxydiethoxysilane, ethylmonomethoxydiethoxysilane, propylmonomethoxydiethoxysilane, butylmonomethoxydiethoxysilane, methylmonomethoxydipropoxysilane, methylmonomethoxydiphenyloxysilane, ethylmonomethoxydipropoxysilane, ethylmonomethoxydiphenyloxysilane, propylmonomethoxydipropoxysilane, propylmonomethoxydiphenyloxysilane, butylmonomethoxydipropoxysilane, butylmonomethoxydiphenyloxysilane, methylmethoxyethoxypropoxysilane, propylmethoxyethoxypropoxysilane, butylmethoxyethoxypropoxysilane, methylmonomethoxymonoethoxymonobutoxysilane, ethylmonomethoxymonoethoxymonobutoxysilane, propylmonomethoxymonoethoxymonobutoxysilane, and butylmonomethoxymonoethoxymonobutoxysilane, and among them, trimethoxysilane and triethoxysilane are preferable.

Examples of the compound of (C) may include dimethoxysilane, diethoxysilane, dipropoxysilane, diphenyloxysilane, methoxyethoxysilane, methoxypropoxysilane, methoxyphenyloxysilane, ethoxypropoxysilane, ethoxyphenyloxysilane, methyldimethoxysilane, methylmethoxyethoxysilane, methyldiethoxysilane, methylmethoxypropoxysilane, methylmethoxyphenyloxysilane, ethyldipropoxysilane, ethylmethoxypropoxysilane, ethyldiphenyloxysilane, propyldimethoxysilane, propylmethoxyethoxysilane, propylethoxypropoxysilane, propyldiethoxysilane, propyldiphenyloxysilane, butyldimethoxysilane, butylmethoxyethoxysilane, butyldiethoxysilane, butylethoxypropoxysilane, butyldipropoxysilane, butylmethylphenyloxysilane, dimethyldimethoxysilane, dimethylmethoxyethoxysilane, dimethyldiethoxysilane, dimethylphenyloxysilane, dimethylethoxypropoxysilane, dimethyldipropoxysilane, diethyldimethoxysilane, diethylmethoxypropoxysilane, diethyldiethoxypropoxysilane, dipropyldimethoxysilane, dipropyldiethoxysilane, dipropyldiphenyloxysilane, dibutyldimethoxysilane, dibutyldiethoxysilane, dibutyldipropoxysilane, dibutylmethoxyphenyloxysilane, methylethyldimethoxysilane, methylethyldiethoxysilane, methylethyldipropoxysilane, methylethyldiphenyloxysilane, methylpropyldimethoxysilane, methylpropyldiethoxysilane, methylbutyldimethoxysilane, methylbutyldiethoxysilane, methylbutyldipropoxysilane, methylethylethoxypropoxysilane, ethylpropyldimethoxysilane, ethylpropylmethoxyethoxysilane, dipropyldimethoxysilane, dipropylmethoxyethoxysilane, propylbutyldimethoxysilane, propylbutyldiethoxysilane, dibutylmethoxypropoxysilane, and butylethoxypropoxysilane, and among them, dimethoxysilane, diethoxysilane and methyldimethoxysilane are preferable.

When the via or the trench is formed by dry etching (using fluorocarbon based gas), it becomes possible to remove the filler material layer by etching fast equally to or faster than the case of the low dielectric material layer by the use of alkoxysilane based filler material in the method of the present invention in this way, and the steps may be simplified. Even when the alkoxysilane based material remains in the trench or the via after the completion of the dry etching, it is possible to easily remove them using a stripping solution containing hydrofluoric acid. On the contrary, when an organic material or the conventional filler material combining the organic material with the alkoxysilane based material is used, it may become difficult to remove the residual organic material in the via hole. Specifically, such a residual organic material is removed by oxygen plasma ashing, and this removal treatment may give damage to the low dielectric material layer.

In the method of the present invention, materials used for the low dielectric material layer may include those described later. Among them, when an Si based material having at least methyl group is used, it is preferable that a constitution ratio of total of the component represented by the general formula (B) and the component represented by the general formula (C) be 50% by weight or more in the spin-on-glass material in order to remove the filler material layer by etching at a speed equal to or faster than that for the low dielectric material layer.

When the low dielectric material layer is a hydrogen silsesquioxane based material, it is preferable that a constitution ratio of a component represented by the general formula (B) wherein R₅ is a hydrogen atom be 50% by weight or more or that a polyalkylene glycol based polymer be combined therewith, for the same reason as the above.

In the method of the present invention, each component of the above (A), (B) and (C) is dissolved in an organic solvent to prepare a coating solution for forming the filler material layer. Examples of the organic solvent used may include monovalent alcohol such as methyl alcohol, ethyl alcohol, propyl alcohol and butyl alcohol; polyvalent alcohol such as ethylene glycol, diethylene glycol, propylene glycol, glycerine, trimethylol propane and hexane triol; monoethers of polyvalent alcohol such as ethylene glycol monomethyl ether, ethylene glycol monoethyl ether, ethylene glycol monobutyl ether, diethylene glycol monomethyl ether, diethylene glycol monoethyl ether, diethylene glycol monopropyl ether, propylene glycol monomethyl ether, propylene glycol monoethyl ether, propylene glycol monopropyl ether and propylene glycol monobutyl ether; esters such as methyl acetate, ethyl acetate and butyl acetate; ketones such as acetone, methyl ethyl ketone and methyl isoamyl ketone; polyvalent alcohol ether where polyvalent alcohol ether is alkyl-etherified, such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether and diethylene glycol methyl ethyl ether. Among them, polyvalent ethers where polyvalent alcohol ether is alkyl-etherified, particularly alkylene glycol dialkyl ethers are preferable.

The above organic solvent may be used alone or in combination of two or more, and an amount thereof to be used is preferably in the range of 10 to 30 moles per one mole of total silane compounds. The coating solution prepared in this way may be used directly, and may be used by diluting with a dilution solvent for adjusting a solid concentration in the coating solution. As the dilution solvent, the aforementioned organic solvent may be used. In the preparation of the coating solution, if the alcohol solvent used or alcohol produced by a hydrolytic reaction of the silane compound remains at more than 15% by weight based on a total amount of the coating solution, H-Si group and alcohol are reacted to easily produce RO-Si group, the coating solution turns into a gel to deteriorate storage stability, and cause cracks. When an alcohol component is excessively contaminated, the alcohol may be removed by distillation under reduced pressure. The distillation under reduced pressure may be performed at a vacuum degree of 30 to 300 mmHg, preferably 50 to 200 mmHg at a temperature of 20 to 50°C for 2 to 6 hours.

The spin-on-glass material used for the present invention may substantially be free of the highly light-absorbing dye, since the addition of such a dye is not preferable because the dye causes intermixing and lowers the storage stability.

As a conductor material for the wiring layer, Cu is preferable. Other than Cu, Cu alloys, Al and Al alloys may also be used. An embedded wiring layer may be formed by electrolytic plating, and the method therefor is not particularly limited.

Examples of the materials which may be used as the low dielectric material layer may include carbon dope oxide (SiOC)-based, methyl silsesquioxane (MSQ)-based and hydrogen silsesquioxane (HSQ)-based low dielectric materials. Specific examples of the carbon dope oxide-based low dielectric material may include Black Diamond (trade name) supplied from Applied Materials, Coral (trade name) supplied from Novelus Systems and Aurora (trade name) supplied from ASM Japan. Specific examples of the methyl silsesquioxane-based low dielectric material may include materials which are commercially available under the trade names of "OCD T-9", "OCD T-11", "OCL T-31 ", "OCL T-37" and "OCL T-39" supplied from Tokyo Ohka Kogyo Co., Ltd. Specific examples of the hydrogen silsesquioxane-based low dielectric material may include materials which are commercially available under the trade names of "OCD T-12" and "OCL T-32" supplied from Tokyo Ohka Kogyo Co., Ltd.

In the method of the present invention, the low dielectric materila layer may be formed on the wiring layer or a barrier film (SiN, SiC, SiCN, Ta and TaN) formed on the wiring layer. Baking of the low dielectric material layer is usually performed by hard baking at 350°C or above.

Photoresist materials commonly used for i-ray, g-ray of a mercury lamp, KrF excimer laser, ArF excimer laser, F₂ excimer laser and electron ray beam (EB) may be used for the aforementioned photoresist layer by a lithography method.

In the first method for forming the semiconductor multilayer wiring of the present invention, it is possible to use commercially available materials capable of being removed by CF₄-based etching gas or N₂+O₂ based etching gas commonly used, as the reflection preventing film 35a capable of being removed by the aforementioned dry etching. Shape deterioration of the photoresist pattern by the reflection of exposure light from the substrate may be prevented by this reflection preventing film. Examples of the commercially available materials for the reflection preventing film may include materials which are commercially available under the trade names of "SWK-EX1 D55", "SWK-EX3", "SWK-EX4", "SWK-T5D60 and "SWK-T7" supplied from Tokyo Ohka Kogyo Cp., Ltd., materials which are commercially available under the trade names of "DUV-42", "DUV-44", "ARC-28" and "ARC-29" supplied from Brewer Science, and materials which are commercially available under the trade names of "AR-3" and "AR-19" supplied from Shipley.

When the reflection preventing film is used, the second etching space is formed, the filler material is removed, and subsequently the photoresist film and the reflection preventing film are removed.

The reflection preventing film is usually removed by an oxygen plasma ashing treatment. However, in this case, it is not preferable to employ the ashing treatment because the low dielectric material layer may be damaged thereby. Thus, the removal of the reflection preventing film may be realized by removing the residual filler material under the reflection preventing film, whereby the reflection preventing film may be lifted off.

Particularly when the hydrogen silsesquioxane-based material is used for the low dielectric material layer, the surface of the low dielectric material layer is reformed by irradiating plasma generated from inert gas such as He and Ar. This surface reforming enables to remove the residual reflection preventing film and the photoresist pattern by the oxygen plasma treatment without impairing the low dielectric material layer.

As the material which constitutes the reflection preventing film, the following resin composition may be used in addition to the aforementioned composition commonly used. That is, the resin composition containing a resin component having at least a substituent which is capable of releasing a terminal group to produce a sulfonic acid residue by receiving predetermined energy and a solvent may be used.

The resin component may be the one which is characterized by having at least a repeating unit represented by the following general formula (1): 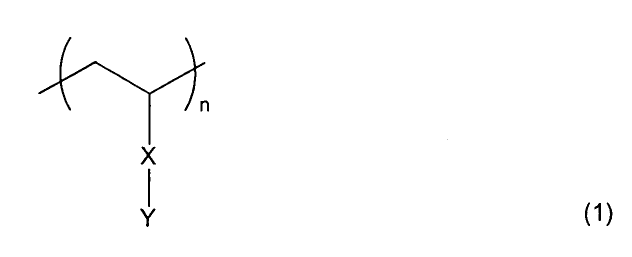 wherein n represents an integer of 1 or more, X is a straight or branched alkyl chain, aromatic or alicyclic cyclic alkyl chain or alkyl ester chain having 1 to 10 carbon atoms, and Y is a substituent group which produces a sulfonic acid residue upon application of predetermined energy.

The predetermined energy applied to produce the sulfonic acid residue may be a heating treatment at 80° or above. Such predetermined energy applied is further facilitated by synergistic effect of heating and alkali in a removing treatment.

As the substituent group Y in the above general formula (1), -SO₃R₁ or -SO₃⁻R₂⁺ (wherein R₁ and R₂ are monovalent organic groups) is preferable.

As the organic group R₁, one selected from an alkyl group or hydroxy alkyl group having 1 to 10 carbon atoms is preferable.

As the organic group R₂, at least one selected from alkanol amine and alkyl amine is preferable.

Furthermore, as the resin component having at least the substituent which is capable of releasing a terminal group to produce the sulfonic acid residue upon application of predetermined energy, a copolymer of or a mixed resin of any of the aforementioned resin component with acrylic acid or methacrylic acid or a derivative thereof may be used.

When the copolymer or the mixed resin is used as the resin component, a copolymerization ratio or a mixing ratio is not particularly limited as long as resistance to a resist developer is retained and an effect capable of being removed by the resist-stripping solution is kept.

Still further, the resin component having at least the substituent group which is capable of releasing a terminal group to produce the sulfonic acid residue upon application of predetermined energy may be:
a copolymer of the copolymer or the mixed resin of any of the aforementioned resin component and acrylic acid or methacrylic acid or a derivative thereof, and the repeating unit represented by the following formula (2): 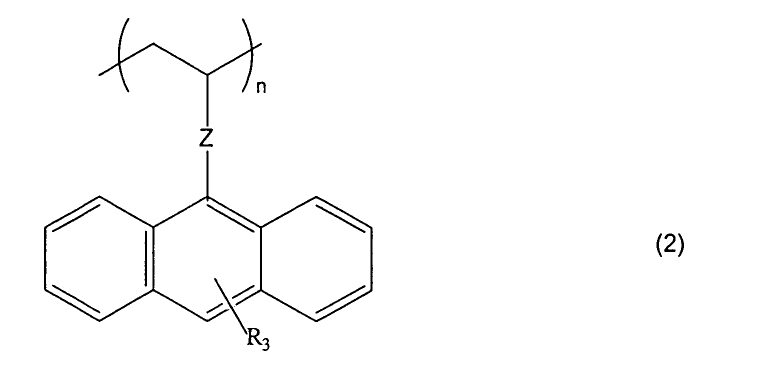 wherein n is an integer of 1 or more, R₃ is at least one member selected from the group consisting of a hydrogen atom, a fluorine atom, a hydroxyl group, a carboxyl group, a C1 to C5 hydroxyalkyl group and a C1 to C5 alkoxyalkyl group, and Z represents a C1 to C10 linear or branched alkyl chain, an aromatic or alicyclic linear alkyl chain or alkyl ester chain; or
a mixed resin of the copolymer or the mixed resin of any of the aforementioned resin component and acrylic acid or methacrylic acid or a derivative thereof, together with a resin compound having the repeating unit represented by the formula (2).

If a copolymer is prepared using the derivative of the above general formula (2) and the reflection preventing film is constituted using the that copolymer as the resin component, the resulting resin component of the reflection preventing film contains anthracene group. This is particularly preferable for lithography with KrF excimer laser because anthracene significantly absorbs KrF excimer laser.

As solvents used for this reflection preventing film forming material, those conventionally used for lower layer film forming materials may be used without particular limitation.

When the reflection preventing film is formed from "the resin composition containing the resin component having at least the substituent group which is capable of releasing a terminal group to produce the sulfonic acid residue upon application of predetermined energy and the solvent", it becomes possible to easily perform removal by a stripping solution for the photoresist used in the usual lithography treatment in the step of removing the photoresist film and the reflection preventing film after forming the second etching space and removing the filler material. As a result, a risk of damage for the low dielectric material layer when the reflection preventing film is removed using the oxygen plasma ashing may be avoided. It also becomes easy to rework, i.e. to retrieve the semiconductor substrate when the formation of the photoresist pattern is failed.

Additionally, as the other composition for forming the reflection preventing film, a resin composition containing a mixture of polytitanoxane and polysiloxane or a copolymer thereof may be used. In this resin composition, a mixture of a reactant obtained by condensation of titanoxane: RₘTi(OR)₍₄₋ₘ₎ and a reactant obtained by condensation of siloxane: RₙSi(OR)₍₄₋ₙ₎ or a reactant obtained by condensation of these components together is a major ingredient, and if necessary, an activator and a crosslinking accelerating agent are contained. In the formulae, R is mainly an alkyl group and may be the same or different, and m and n are integers of 0 to 3. In this major ingredient, a content of Ti is 0.1 to 99.9% and preferably 5 to 70%. The solvent in this resin composition is not particularly limited and may be any solvent, as long as the solvent can dissolve the major ingredient resin and form the film to an extent not to cause intermixing with the resist by treating with heat after coating on the substrate and drying.

When the reflection preventing film is formed from the aforementioned "resin composition containing the mixture of polytitanoxane and polysiloxane or the copolymer thereof", it becomes possible to easily remove with the stripping solution for the photoresist used in the usual lithography treatment in the step of removing the photoresist film and the reflection preventing film after forming the second etching space and removing the filler material. As a result, the risk of damage for the low dielectric material layer when the reflection preventing film is removed using the oxygen plasma ashing may be avoided. It also becomes easy to rework, i.e., to retrieve the semiconductor substrate when the formation of the photoresist pattern is failed.

In the second method for forming the semiconductor multilayer wiring of the present invention, the developer-soluble reflection preventing film 35b is not particularly limited as long as the removal thereof may be easily performed by an alkali aqueous solution commonly used in the development step of the photoresist layer (e.g., 2.38% by weight tetramethyl ammonium hydroxide (TMAH)) and reflected light from the substrate may be effectively reduced. As the reflection preventing film capable of being removed by such an alkali aqueous solution, IMBARC SERIES (trade name) sold by Brewer Science is available, and it is possible to use such a commercially available one. This may prevent shape deterioration of the photoresist pattern by the reflection of exposure light from the substrate, may be removed simultaneously by an alkali developer upon the development of the photoresist, and contributes the reduction of steps.

By providing the developer-soluble reflection preventing film of the present invention, it becomes possible to properly and simply perform a rework step for retrieving the substrate when the formation of the photoresist pattern has come to poor. When the conventional reflection preventing film is used, this rework step is performed by the oxygen plasma ashing, but this ashing treatment is likely to harmfully affect the etching of the filler material containing the alkoxysilane material. On the contrary, when the developer-soluble reflection preventing film of present invention is used, the film may be easily removed by the alkali aqueous solution, and thus, the rework may be easily performed without harmfully affecting the filler material.

The removal of the filler material left in the etching space after forming the second etching space may be performed using buffered hydrofluoric acid, and the stripping solution for the photoresist used for the usual lithography step may also be used. Examples of such a stripping solution for the photoresist may include a stripping solution whose major ingredient is a salt of hydrofluoric acid with a base containing no metal ion, a stripping solution whose major ingredient is water-soluble amine such as alkanol amine and alkyl amine and a stripping solution whose major ingredient is tetraalkyl ammonium hydroxide.

As effects by the aforementioned first and second methods for forming the semiconductor multilayer wiring of the present invention, the followings may be achieved.
(i) When the trench/via is formed in the dual damascene process, it becomes possible to remove the filler material in the trench/via by etching at a speed equal to or faster than that for the low dielectric material layer.
(ii) In the first method for forming the semiconductor multilayer wiring, it becomes possible to easily remove the filler material left in the via hole after etching removal by the stripping solution containing hydrofluoric acid. In the second method for forming the semiconductor multilayer wiring, it becomes possible to easily remove the filler material left in the via hole after the etching removal by the stripping solution for the photoresist used in the usual lithography.
(iii) In the conventional example in which the organic film is the filler material, the removal by the oxygen plasma ashing has been required, but this step may be omitted in the present invention. Therefore, it becomes possible to eliminate the damage for the low dielectric material layer (Si-R bond →Si-OH bond) and variation of the dielectric constant (k).
(iv) The filler material which substantially combines no organic additive (highly light-absorbing component or dye in prior art) is used. Therefore, the deterioration with time of the spin-on-glass material may be prevented. This may enhance storage stability of the filler material and the stability of the film, and enhance the flexibility of the step management. The intermixing which occurs between the layer and the upper layer may be prevented.
(v) In the process where the photoresist layer is provided on a just upper layer of the spin-on-glass material layer, variations among lots have frequently occurred in evaluation of matching to the resist film. On the contrary, the matching to the photoresist layer in the present invention becomes easy because the constitution is through the reflection preventing film.
(vi) In the second method for forming the semiconductor multilayer wiring, the developer-soluble reflection preventing film may be removed simultaneously upon the development of the photoresist, and thus, it becomes possible to further simplify the steps.

The present invention will be illustrated with the reference to the following Examples. The Examples shown below are only exemplifications suitably illustrating the invention and do not limit the present invention.

The following Examples 1 to 6 and Comparative Example 1 relate to the first method for forming the semiconductor multilayer wiring of the present invention.

### (Example 1)

Four layers, i.e., an SiN layer, a first low dielectric material layer composed of a hydrogen silsesquioxane-based low dielectric material (trade name: OCD T-12 supplied from Tokyo Ohka Kogyo Co., Ltd.), an SiN layer and a second dielectric material layer composed of the hydrogen silsesquioxane-based low dielectric material (trade name: OCD T-12 supplied from Tokyo Ohka Kogyo Co., Ltd.) were sequentially laminated on a substrate on which a copper wiring had been formed to form an interlayer insulating layer of 6000 angstroms.

A first reflection preventing film with a film thickness of 770 angstroms composed of ARC-29 (supplied from Brewer Science) was formed on the above interlayer insulating layer, a first photoresist layer with a film thickness of 4000 angstroms was formed thereon, and exposure and development were given. The first photoresist layer was formed using a resist composition (trade name: TArF-7a21 supplied from Tokyo Ohka Kogyo Co., Ltd.) whose major ingredient was acryl-based polymer.

An etching treatment was given to the interlayer insulating layer using the resulting photoresist pattern as a mask to form a via hole with a diameter of 200 nm.

A filler material prepared at a step separated from the laminating and etching steps was uniformly coated on the interlayer insulating layer by spin coating so that a film thickness was 4000 angstroms to embed the via hole with the filler material.

The filler material was prepared as follows. That is, 236.58 g (1.44 mol) of triethoxysilane, 108.72 g (0.72 mol) of tetramethoxysilane, 2117.71 g (20.4 mol) of propylene glycol dimethyl ether, 129.6 g (7.2 mol) of water and 432 µL of concentrated nitric acid were mixed to obtain a solution. This solution was distilled under reduced pressure at 150 mmHg at 40°C for 4 hours to prepare the filler material with a solid concentration of 9.0% by weight and an alcohol concentration of 3.8% by weight.

A second reflection preventing film with a film thickness of 770 angstroms composed of ARC-29 (supplied from Brewer Science) was formed on the filler material uniformly coated on the substrate surface in order to embed the via hole with the filler material as described above, a second photoresist layer with a film thickness of 4000 angstroms was formed thereon, and the exposure and the development were given. The second photoresist layer was formed from the same composition as in the first photoresist layer.

An uncovered part of the reflection preventing film was removed using etching gas composed of the mixed gas of N₂ + O₂ using the resulting photoresist pattern as the mask.

Subsequently, a substantial part of the interlayer insulating layer was removed using etching gas composed of the mixed gas of CF₄ + CHF₃ using the photoresist pattern as the mask to form a trench. The filler material left in the via hole after this etching treatment was removed using 0.1% by weight buffered hydrofluoric acid.

As a result, a dual damascene structure having the via hole and the trench was formed by these simple steps without giving damage to the low dielectric material layer and without alteration of the dielectric constant.

### (Examples 2 to 5)

Each dual damascene structure was formed in the same way as in Example 1 except that the first and second reflection preventing films in the Example 1 were constituted from the following four resin compositions.

As the reflection preventing film-forming materials, the following resin compositions of (A), (B), (C) and (D) were prepared.
(A) Resin composition where a resin component composed of ethyl p-styrenesulfonate was dissolved in a solvent composed of γ-butyrolactone/ethyl lactate (2:8) and a solid concentration was adjusted to 6% by weight.
(B) Resin composition where a resin component composed of ethyl p-styrenesulfonate : hydroxyethyl acrylate (=5:5) and Cymel 1172 (tetramethylol glycoluril supplied from Mitsui Cyanamid Co., Ltd.) at an amount equivalent to 20% by weight based on the resin component amount were dissolved in the solvent composed of ethyl lactate and the solid concentration was adjusted to 6% by weight.
(C) Resin composition where a resin component composed of ethyl p-styrenesulfonate : 9-hydroxyanthracenyl acrylate (=5:5) was dissolved in the solvent composed of γ-butyrolactone/ethyl lactate (2:8) and the solid concentration was adjusted to 6% by weight.
(D) Resin composition where the rein component composed of p-styrene ethyl sulfonate : hydroxyethyl acrylate : 9-hydroxyanthracenyl acrylate (=4:3:3) and Cymel 1172 (tetramethylol glycoluril supplied from Mitsui Cyanamid Co., Ltd.) at an amount equivalent to 20% by weight based on the resin component amount and Megafac R08 (fluorine-based surfactant supplied from Dainippon Ink and Chemicals Incorporated) at an amount equivalent to 1000 ppm based on the solid amount of the aforementioned two were dissolved in the solvent composed of ethyl lactate and the solid concentration was adjusted to 6% by weight.

These resin compositions of (A), (B), (C) and (D) were the materials for forming the first and second reflection preventing films in the Example 1. Using these resin composition as reflection preventing film forming materials, the wiring structure having the trench and via hole was formed in the same way as in Example 1 except that the film thickness of each reflection preventing film was 2000 angstroms. The reflection preventing film was obtained by coating each resin composition and heating at 200°C for 90 seconds.

As a result, when any of the resin compositions of (A), (B), (C) and (D) was used, the dual damascene structure having the via hole and the trench was produced by these simple steps without damaging the low dielectric material layer and without altering the dielectric constant.

### (Example 6)

A dual damascene structure was formed in the same way as in Example 1 except that the first and second reflection preventing films in Example 1 were constituted from the following resin composition.

Tetraisopropoxy titanium (100 g) was dissolved in 338 g of ethanol, and then 121 g of acetic acid and 357 g of acetyl acetone were added to obtain a mixture. This mixture was stirred for 4 hours and subsequently left stand for 16 hours to obtain a solution of 10% polytitanoxane.

Subsequently, 113 g of methanol, 312 g of acetyl acetone and 324 g of acetic acid were added to 324 g of tetraethoxysilane to obtain a mixture. This mixture was stirred for 6 hours and subsequently left stand for 16 hours to obtain a solution of 9% polysiloxane.

A resin mixed solution obtained by mixing the polytitanoxane solution and the polysiloxane solution at 1:1 and diluting with butyl cellosolve was a material for forming the first and second reflection preventing films corresponding to those in Example 1. A wiring structure having the trench and the via hole was formed using this resin mixed solution as a reflection preventing film-forming material in the same way as in Example 1 except that the film thickness of the reflection preventing film was 1240 angstroms. The reflection preventing film was obtained by coating each resin composition and heating at 90°C for 90 seconds and subsequently 220°C for 600 seconds.

As a result, when the reflection preventing film was also formed using this resin composition, the dual damascene structure having the via hole and the trench was produced by these simple steps without damaging the low dielectric material layer and without altering the dielectric constant.

### Comparative Example 1

A dual damascene structure was formed by the same composition and manipulation as in Example 1 except that the composition which formed the filler material used in Example 1 was constituted from a solution of 30% by weight methoxymethylated benzoguanamine in propylene glycol monomethyl ether acetate.

As a result, almost all part of the filler material remained even after etching of the filler material accompanied with "a dry etching treatment by etching gas composed of the mixed gas of CF₄ + CHF₃" for forming the trench. The filler material could not be removed by the subsequent treatment using a release washing solution.

Thus, in order to remove the residual filler material which could not be removed, the dry etching treatment was given using the etching gas composed of the mixed gas of N₂ + O₂, and consequently, the filler material was removed, but it was found by observation using a scanning electron microscope (SEM) that the surface of the low dielectric material layer had been damaged.

The following Example 7 and Comparative Example 2 relate to the second methods for forming the semiconductor multilayer wiring of the present invention.

### (Example 7)

Four layers, i.e., an SiN layer, a first low dielectric material layer composed of a hydrogen silsesquioxane-based low dielectric material (trade name: OCD T-12 supplied from Tokyo Ohka Kogyo Co., Ltd.), an SiN layer and a second dielectric material layer composed of the hydrogen silsesquioxane-based low dielectric material (trade name: OCD T-12 supplied from Tokyo Ohka Kogyo Co., Ltd.) were sequentially laminated on a substrate on which a copper wiring had been formed to form an interlayer insulating layer of 6000 angstroms.

A first developer-soluble reflection preventing film with a film thickness of 770 angstroms composed of IMBARC 10-7 (trade name, supplied from Brewer Science) was formed on the interlayer insulating layer, a first photoresist layer with a film thickness of 4000 angstroms was formed thereon, and the exposure and the development were given. At that time, an uncovered part of the reflection preventing film uncoated with the photoresist pattern was simultaneously removed. The first photoresist layer was formed using a resist composition (trade name: TArF-7a21 supplied from Tokyo Ohka Kogyo Co., Ltd.) whose major ingredient was an acryl-based polymer.

The interlayer insulating layer was etched using the resulting photoresist pattern as a mask to form a via hole with a diameter of 200 nm.

A filler material prepared at a step separated from the laminating and etching steps was uniformly coated on the interlayer insulating layer by spin coating so that a film thickness was 4000 angstroms to embed the via hole with the filler material.

The filler material was prepared as follows. That is, 236.58 g (1.44 mol) of triethoxysilane, 108.72 g (0.72 mol) of tetramethoxysilane, 2117.71 g (20.4 mol) of propylene glycol dimethyl ether, 129.6 g (7.2 mol) of water and 432 µL of concentrated nitric acid were mixed to obtain a solution. This solution was distilled under reduced pressure at 150 mmHg at 40°C for 4 hours to prepare the filler material with a solid concentration of 9.0% by weight and an alcohol concentration of 3.8% by weight.

A second developer-soluble reflection preventing film with a film thickness of 770 angstroms composed of IMBARC 10-7 (trade name, supplied from Brewer Science) was formed again on the filler material layer uniformly coated on the substrate surface in order to embed the via hole with the filler material as described above. Furthermore, a second photoresist layer (same composition as in the first photoresist layer) with a film thickness of 4000 angstroms was formed thereon. Patterned exposure for forming a trench was performed and the development by an alkali developer was given to remove the resist of the exposed portion and the second developer-soluble reflection preventing film simultaneously.

A substantial part of the interlayer insulating layer was removed using etching gas composed of the mixed gas of CF₄ +CHF₃ and using the resulting photoresist pattern as a mask to form the trench. The filler material left in the via hole after this etching treatment was removed using 0.1 % by weight buffered hydrofluoric acid.

As a result, the dual damascene structure having the via hole and the trench was produced by these simple steps without damaging the low dielectric material layer and without altering the dielectric constant.

### (Comparative Example 2)

A dual damascene structure was formed by the same composition and manipulation as in Example 1 except that the composition which formed the filler material used in Example 1 was constituted from a solution of 30% by weight methoxymethylated benzoguanamine in propylene glycol monomethyl ether acetate.

As a result, almost all part of the filler material remained even after etching of the filler material accompanied with "a dry etching treatment by etching gas composed of the mixed gas of CF₄ + CHF₃" for forming the trench. The filler material could not be removed by the subsequent treatment using a release washing solution.

Thus, in order to remove the residual filler material which could not be removed, the dry etching treatment was given using the etching gas composed of the mixed gas of N₂ + O₂, and consequently, the filler material was removed, but it was found by observation using a scanning electron microscope (SEM) that the surface of the low dielectric material layer had been damaged.

### INDUSTRIAL APPLICABILITY

As described in the above, the method for forming the semiconductor multilayer wiring of the present invention may reduce the steps and enhance the flexibility in the step management without deteriorating the low dielectric material layer which constitutes the interlayer insulating layer, and has an excellent effect that the wiring having the excellent property may be formed efficiently and inexpensively, in the formation process of the semiconductor multilayer wiring using the dual damascene process.

## Claims

1. A method for forming a semiconductor multilayer wiring comprising a lower wiring layer formed on a semiconductor substrate and an upper wiring layer formed thereon by the intermediary of an interlayer insulating layer, said lower wiring layer and said upper wiring layer are connected by a via wiring which penetrates through said interlayer insulating layer, said method comprising:
a step of forming the interlayer insulating layer wherein said interlayer insulating layer composed of at least a low dielectric material layer is laminated on said lower wiring layer;
a step of forming a first etching space wherein the first etching space is formed in said interlayer insulating layer by forming a photoresist layer on said interlayer insulating layer, giving patterned exposure thereto, developing to form a photoresist pattern, and etching using this photoresist pattern as a mask;
a step of embedding wherein a filler material which at least contains a spin-on-glass material as a major ingredient is applied to said interlayer insulating layer, to embed said filler material in said first etching space;
a step of forming a reflection preventing film wherein the reflection preventing film capable of being processed by dry etching is formed on a filler material layer formed on said interlayer insulating layer;
a step of forming a photoresist pattern wherein the photoresist pattern is formed by forming a photoresist layer on said reflection preventing film, irradiating said photoresist layer with patterned light, and developing by an alkali developer;
a step of processing the reflection preventing film wherein an exposed part of said reflection preventing film is processed by dry etching using said photoresist pattern as a mask;
a step of forming a second etching space and removing the filler material wherein etching is performed using said photoresist pattern as a mask to remove said interlayer insulating layer above said first etching space in accordance with a predetermined pattern for forming the second etching space which communicates with said first etching space, and simultaneously to remove the filler material in said first etching space; and
a step of simultaneous wiring formation wherein said first and second etching spaces are simultaneously embedded with a conductor material to simultaneously form a via wiring and an upper wiring layer.

2. The method for forming the semiconductor multilayer wiring according to claim 1, wherein said spin-on-glass material is one obtained by hydrolyzing at least one compound selected from:
(A) a compound represented by Si(OR¹)ₐ(OR²)_{b}(OR³)_{c}(OR⁴)_{d} wherein R¹, R², R³ and R⁴ are each independently an alkyl group having 1 to 4 carbon atoms or a phenyl group, and a, b, c and d are integers which fulfill a condition of 0≤a≤4, 0≤b≤4, 0≤c≤4, 0≤d≤4 and a+b+c+d=4;
(B) a compound represented by R⁵Si(OR⁶)ₑ(OR⁷)_{f}(OR⁸)_{g} wherein R⁵ is a hydrogen atom or an alkyl group having 1 to 4 carbon atoms, R⁶, R⁷ and R⁸ are each an alkyl group having 1 to 3 carbon atoms or a phenyl group, and e, f and g are integers which fulfill a condition of 0≤e≤3, 0≤f≤3, 0≤g≤3 and e+f+g=3; and
(C) a compound represented by R⁹R¹⁰Si(OR¹¹)ₕ(OR¹²)ᵢ wherein R⁹ and R¹⁰ are a hydrogen atom or an alkyl group having 1 to 4 carbon atoms, R¹¹ and R¹² are each an alkyl group having 1 to 3 carbon atoms or a phenyl group, and h and i are integers which fulfill a condition of 0≤h≤2, 0≤i≤2 and h+i=2.

3. The method for forming the semiconductor multilayer wiring according to claim 2, wherein said low dielectric material layer is formed from an Si-based material having at least methyl group and said spin-on-glass material is prepared so that a total content percentage of said compound (B) and said compound (C) is 50% or more.

4. The method for forming the semiconductor multilayer wiring according to claim 3, wherein a hydrogen silsesquioxane-based material is used as said Si-based material and said spin-on-glass material is prepared so that a content percentage of the compound (B) wherein said R⁵ is a hydrogen atom is 50% or more.

5. The method for forming the semiconductor multilayer wiring according to claim 1, wherein said spin-on-glass material is dissolved in an organic solvent, and the organic solvent is a polyvalent alcohol ether obtained by alkyl-etherifying hydroxyl group of a polyvalent alcohol.

6. The method for forming the semiconductor multilayer wiring according to claim 1, wherein said reflection preventing film is constituted from a resin composition containing a resin component having at least a substituent group which is capable of releasing a terminal group to produce a sulfonic acid residue upon application of predetermined energy, and a solvent.

7. The method for forming the semiconductor multilayer wiring according to claim 6, wherein said resin component at least has a repeating unit represented by the following formula (1): 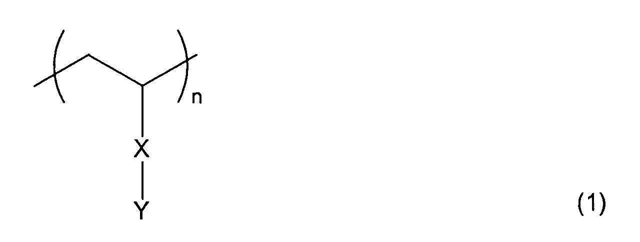 wherein n represents an integer of 1 or more, X is a straight or branched alkyl chain, aromatic or alicyclic cyclic alkyl chain or alkyl ester chain having 1 to 10 carbon atoms, and Y is a substituent group which is capable of producing a sulfonic acid residue upon application of the predetermined energy.

8. The method for forming the semiconductor multilayer wiring according to claim 1, wherein said reflection preventing film is constituted from a resin composition containing a mixture of polytitanoxane and polysiloxane or a copolymer thereof.

9. The method for forming the semiconductor multilayer wiring according to claim 1, further comprising a step of removing the filler material wherein the filler material remaining in said first etching space is removed by a stripping solution after the step of forming said second etching space.

10. A method for forming a semiconductor multilayer wiring comprising a lower wiring layer formed on a semiconductor substrate and an upper wiring layer formed thereon by the intermediary of an interlayer insulating layer, said lower wiring layer and said upper wiring layer are connected by a via wiring which penetrates through said interlayer insulating layer, said method comprising:
a step of forming an interlayer insulating layer wherein said interlayer insulating layer composed of at least a low dielectric material layer is laminated on said lower wiring layer;
a step of forming a first etching space wherein the first etching space is formed in said interlayer insulating layer by forming a photoresist layer on said interlayer insulating layer, giving patterned exposure thereto, developing to form a photoresist pattern, and etching using this photoresist pattern as a mask;
a step of embedding wherein a filler material which at least contains a spin-on-glass material as a major ingredient is applied to said interlayer insulating layer, to embed said filler material in said first etching space;
a step of forming a reflection preventing film wherein a developer-soluble reflection preventing film is formed on a filler material layer formed on said interlayer insulating layer;
a step of forming a photoresist wherein a photoresist layer is formed on said developer-soluble reflection preventing film;
a step of developing the resist and removing the reflection preventing film wherein said photoresist layer is irradiated with patterned light and, with an alkali developer, the photoresist layer is developed, and simultaneously a part of the reflection preventing film that is not covered by the remaining photoresist pattern which has remained during the development is removed;
a step of forming a second etching space and removing the filler material wherein etching is performed using said photoresist pattern as a mask to remove said interlayer insulating layer above said first etching space in accordance with a predetermined pattern for forming the second etching space which communicates with said first etching space, and simultaneously to remove the filler material in said first etching space; and
a step of simultaneous wiring formation wherein said first and second etching spaces are simultaneously embedded with a conductor material to simultaneously form a via wiring and an upper wiring layer.

11. The method for forming the semiconductor multilayer wiring according to claim 10, wherein said spin-on-glass material is one obtained by hydrolyzing at least one compound selected from:
(A) a compound represented by Si(OR¹)ₐ(OR²)_{b}(OR³)_{c}(OR⁴)_{d} wherein R¹, R², R³ and R⁴ are each independently an alkyl group having 1 to 4 carbon atoms or a phenyl group, and a, b, c and d are integers which fulfill a condition : of 0≤a≤4, 0≤b≤4, 0≤c≤4, 0≤d≤4 and a+b+c+d=4;
(B) a compound represented by R⁵Si(OR⁶)ₑ(OR⁷)_{f}(OR⁸)_{g} wherein R⁵ is a hydrogen atom or an alkyl group having 1 to 4 carbon atoms, R⁶, R⁷ and R⁸ are each an alkyl group having 1 to 3 carbon atoms or a phenyl group, and e, f and g are integers which fulfill a condition of 0≤e≤3, 0≤f≤3, 0≤g≤3 and e+f+g=3; and
(C) a compound represented by R⁹R¹⁰Si(OR¹¹)ₕ(OR¹²)ᵢ wherein R⁹ and R¹⁰ are a hydrogen atom or an alkyl group having 1 to 4 carbon atoms, R¹¹ and R¹² are each an alkyl group having 1 to 3 carbon atoms or a phenyl group, and h and i are integers which fulfill a condition of 0≤h≤2, 0≤i≤2 and h+i=2.

12. The method for forming the semiconductor multilayer wiring according to claim 11, wherein said low dielectric material layer is formed from an Si-based material having at least methyl group and said spin-on-glass material is prepared so that a total content percentage of said compound (B) and said compound (C) is 50% or more.

13. The method for forming the semiconductor multilayer wiring according to claim 12, wherein a hydrogen silsesquioxane-based material is used as said Si-based material and said spin-on-glass material is prepared so that a content percentage of the compound (B) wherein said R⁵ is a hydrogen atom is 50% or more.

14. The method for forming the semiconductor multilayer wiring according to claim 10, wherein said spin-on-glass material is dissolved in an organic solvent and the organic solvent is a polyvalent alcohol ether obtained by alkyl-etherifying hydroxyl group of a polyvalent alcohol.

15. The method for forming the semiconductor multilayer wiring according to claim 10, further comprising a step of removing the filler material wherein the filler material remaining in said first etching space is removed by a stripping solution after the step of forming said second etching space.
